(19) **Europäisches Patentamt European Patent Office Office européen des brevets**

(11) **EP 2 015 206 B1**

(12) **FASCICULE DE BREVET EUROPEEN**

(45) Date de publication et mention
de la délivrance du brevet:
**24.02.2010 Bulletin 2010/08**

(51) Int Cl.:
*G06F 17/50* (2006.01)     *B60T 8/00* (2006.01)
*G01M 17/02* (2006.01)

(21) Numéro de dépôt: **08011047.1**

(22) Date de dépôt: **18.06.2008**

(54) **Procédé d' estimation de la marge d'adhérence disponible d'un pneumatique en roulage**

Verfahren zur Abschätzung der verbleibenden nutzbaren Haftung eines rollenden Reifens

Method to estimate the residual useful adhering potential of a rolling tyre

(84) Etats contractants désignés:
**AT BE BG CH CY CZ DE DK EE ES FI FR GB GR
HR HU IE IS IT LI LT LU LV MC MT NL NO PL PT
RO SE SI SK TR**

(30) Priorité: **04.07.2007 FR 0704877**

(43) Date de publication de la demande:
**14.01.2009 Bulletin 2009/03**

(73) Titulaires:
• **Société de Technologie MICHELIN
63000 Clermont-Ferrand (FR)**
• **MICHELIN Recherche et Technique S.A.
1763 Granges-Paccot (CH)**

(72) Inventeur: **Spetler, Frédéric
63190 Lezoux (FR)**

(74) Mandataire: **Dequire, Philippe Jean-Marie Denis
M.F.P. Michelin,
SGD/LG/PI-F35-Ladoux,
23, place des Carmes Déchaux
63040 Clermont-Ferrand Cedex 09 (FR)**

(56) Documents cités:
**EP-A- 0 630 786        EP-A- 0 891 904
EP-A- 1 719 676        WO-A-03/070492
DE-A1- 10 156 823      US-B1- 6 549 842**

**Description**

La présente invention a trait à un procédé d'estimation de la marge d'adhérence disponible d'un pneumatique en roulage sur un sol.

La marge d'adhérence disponible d'un pneumatique est une grandeur particulièrement adaptée pour indiquer à un conducteur de véhicule que son type de conduite sollicite fortement les pneumatiques au risque d'entrainer une perte d'adhérence. Lorsque cette marge d'adhérence diminue, même si les conditions d'adhérence sur le sol ne sont pas faibles, cela veut dire que les sollicitations causées par la conduite sont fortes par rapport au potentiel d'adhérence disponible. La marge de sécurité est faible.

Le document WO 03/066399 propose un procédé de détermination du potentiel d'adhérence d'un pneumatique ainsi que de la marge d'adhérence disponible basé sur le traitement de plusieurs mesures de variation de distance circonférentielle de points fixes dans un repère lié au véhicule, ces points étant situés à des azimuts différents le long de la circonférence dans au moins un flanc du pneumatique.

Ce procédé permet effectivement d'estimer ces grandeurs à partir de mesures de déformation réalisées sur le pneumatique en roulage. Il est toutefois nécessaire qu'il existe une zone de glissement notable dans l'aire de contact pour qu'elle puisse s'appliquer.

L'invention a pour objet un autre procédé de détermination de la marge d'adhérence disponible d'un pneumatique d'un véhicule en roulage sur un sol.

Ce procédé est caractérisé en ce qu'il comporte les étapes suivantes :

- estimer une grandeur $R_{adc\ gli}$, rapport entre l'aire de contact en glissement et l'aire de contact totale du pneumatique sur le sol;
- déterminer, dans une unité de traitement, à partir de ledit rapport et de données préétablies liées au type de pneumatique, le potentiel d'adhérence utilisé $P_{\mu\ util}$ et/ou la marge d'adhérence disponible du pneumatique $P_{\mu\ dispo}$, avec $P_{\mu\ dispo} = 1 - P_{\mu\ util}$; et
- enregistrer dans une mémoire le potentiel d'adhérence utilisé et/ou la marge d'adhérence disponible du pneumatique.

Selon un premier mode de mise en oeuvre, les données préétablies sont un abaque expérimental représentant l'évolution du potentiel d'adhérence utilisé $P_{\mu\ util}$ en fonction de valeurs du rapport $R_{adc\ gli}$ mesurées pour différentes conditions de roulage déterminées.

Selon un second mode de mise en oeuvre, les données préétablies sont des coefficients A, B et C d'une formule analytique F telle que :

$$P_{\mu\ util} = (R_{adc\ gli} + A)^B + C \ \text{ si } \ (R_{adc\ gli} + A)^B + C < 1 \ \text{ et}$$

$$P_{\mu\ util} = 1 \ \text{sinon,}$$

avec A, B et C des constantes dépendantes du type de pneumatique.

Ce procédé est fondé sur une corrélation étroite observée entre la grandeur globale $P_{\mu\ util}$ et le rapport $R_{adc\ gli}$. Dès que le rapport estimé atteint 10%, les estimations du potentiel d'adhérence utilisé et de la marge d'adhérence disponible sont très satisfaisantes.

Dans un premier mode de réalisation, on peut estimer la grandeur $R_{adc\ gli}$ à partir de la mesure du différentiel de vitesse entre la roue et le sol et à partir d'un modèle de fonctionnement du pneumatique reliant ce différentiel de vitesse à la grandeur $R_{adc\ gli}$.

On peut donc, à partir d'un modèle pneumatique, éventuellement précalibré expérimentalement, estimer le rapport de l'aire de contact glissante (soit un rapport de longueurs, soit un rapport de surfaces) à partir de la connaissance de la vitesse de rotation d'une roue (données des codeurs ABS, par exemple) et de la vitesse d'avancement du véhicule. Ce modèle est donc capable de déduire la proportion d'aire de contact glissante à partir du calcul avec les variables d'entrée d'un glissement apparent global de la roue toute entière.

Dans un second mode de réalisation, le pneumatique a un pain de sculpture de la bande de roulement qui est équipé d'un ou plusieurs capteurs permettant chacun de mesurer une grandeur caractéristique des sollicitations que subit localement le pain de sculpture lorsque le pneumatique roule sur un sol. Le procédé d'estimation de la grandeur $R_{adc\ gli}$ comporte alors les étapes suivantes :

- mesurer la grandeur caractéristique lorsque le pneumatique roule sur le sol ;
- produire un signal correspondant aux mesures réalisées ;

- extraire de ce signal une portion relative au passage du ou des capteurs dans l'aire de contact du pneumatique sur le sol et déterminer la longueur totale de l'aire de contact $L_{adc}$;
- déterminer, à partir de la portion extraite du signal, une information caractérisant un début d'un glissement local du pain de sculpture ;
- déterminer une longueur de glissement local du pain de sculpture de la bande de roulement $L_{adc\ gli}$; et
- calculer un rapport $R_{adc\ gli}$ tel que $R_{adc\ gli} = L_{adc\ gli} / L_{adc}$.

La grandeur caractéristique mesurée, située dans le plan du sol, peut être une contrainte longitudinale $\sigma_x$ selon la direction de roulement du pneumatique et/ou transversale $\sigma_y$ à la direction de roulement du pneumatique représentant l'adhérence locale $\mu_{local}$ ou $\mu_{localx}$ ou $\mu_{localy}$ du pain de sculpture de la bande de roulement.

La grandeur caractéristique mesurée peut aussi être un rapport de contraintes représentant l'adhérence locale $\mu_{local}$ ou $\mu_{localx}$ ou $\mu_{localy}$ du pain de sculpture de la bande de roulement et correspond au rapport d'une mesure de contrainte longitudinale $\sigma_x$ et/ou transversale $\sigma_y$ à la direction de roulement sur une contrainte $\sigma_z$, normale à l'axe X de la direction de roulement.

L'invention a aussi pour objet un dispositif d'estimation de la marge d'adhérence disponible d'un pneumatique d'un véhicule évoluant sur un sol, comportant :

- un pneumatique dont au moins un pain de sculpture ou une zone de mesure de la bande de roulement est équipé d'un ou plusieurs capteurs permettant, chacun, de mesurer les contraintes subies localement par le pain de sculpture ou la zone de mesure de la bande de roulement du pneumatique en roulage sur le sol,
- des moyens de transmission d'un signal correspondant aux mesures de ces contraintes ;
- une unité de traitement de signaux capable d'extraire du signal transmis, une portion de signal correspondant au nombre ou à la durée de passage du ou des capteurs dans l'aire de contact du pneumatique en roulage sur le sol ;

caractérisé en ce qu'il comporte, dans l'unité de traitement, un programme pour, à partir du signal extrait, mettre en oeuvre le procédé selon l'invention.

L'invention sera mieux comprise à la lecture de la description qui suit et à l'examen des figures qui l'accompagnent. Celles-ci ne sont présentées qu'à titre indicatif et nullement limitatif de l'invention.

Ces figures montrent :

- Figure 1 : une représentation schématique d'un pneumatique sur une chaussée ;
- Figure 2 : une représentation d'un capteur dans la bande de roulement d'un pneumatique ;
- Figure 3 : une représentation du dispositif de l'invention ;
- Figure 4 et 5 : des courbes avec, en ordonnée, l'adhérence locale déduite de mesures prises dans un pain de mesure présent dans l'aire de contact pour un roulage libre du pneumatique et pour différents couples freineurs et en abscisse la position longitudinale de la mesure dans l'aire de contact ;
- Figure 6 : une courbe représentant en ordonnée et en pourcentage, le potentiel d'adhérence utilisé en fonction, en abscisse, du rapport $R_{adc\ gli}$ représentatif du glissement dans l'aire de contact ; et
- Figure 7 : un organigramme schématique des étapes du procédé selon l'invention.

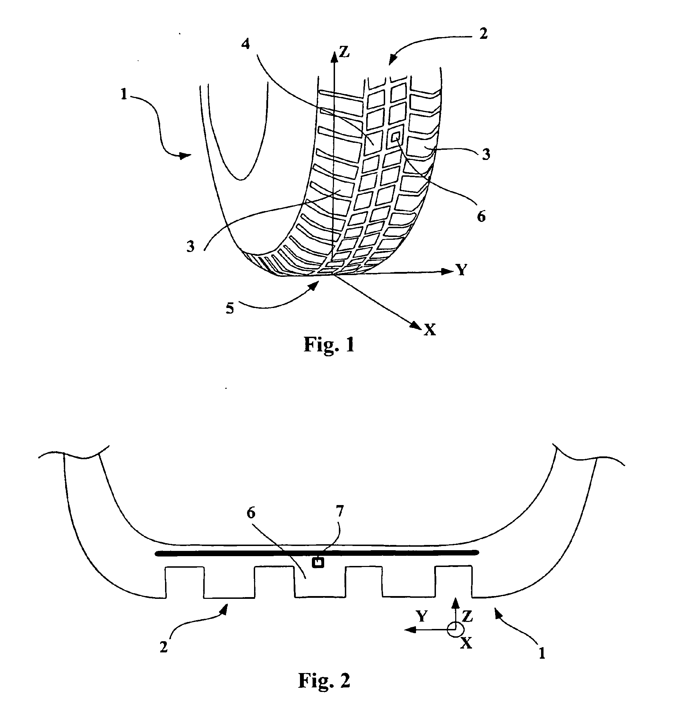

Sur la figure 1 est représenté un pneumatique 1, muni d'une bande 2 de roulement. La bande 2 de roulement comportent deux épaules 3 et une partie centrale 4. La bande 2 en mouvement prend contact sur un sol 5. Ce sol 5 composant une chaussée est représenté par un plan selon deux axes : un axe X et un axe Y. L'axe X est l'axe longitudinal selon le sens de roulement du pneumatique et l'axe Y est l'axe transversal à la direction de roulement du pneumatique. Enfin, un axe Z est défini normal au plan de la chaussée.

Sur la figure 2 est représentée une coupe axiale partielle (i.e. une coupe passant par l'axe de rotation du pneumatique) du pneumatique 1. Y est schématisé un pain de sculpture 6, autrement appelé élément 6, comportant un capteur 7. Dans la description qui suit, on entend par pain de sculpture 6 non seulement un simple élément bien déterminé, mais également une zone locale autour de laquelle des mesures significatives de contraintes sont enregistrées par le capteur 7. Ainsi ces mesures peuvent tout aussi bien être effectuées dans cette zone déterminée, par exemple pour un pneumatique lisse ne disposant d'aucun motif en relief.

Selon les trois axes X, Y et Z décrits précédemment, on mesure, à l'aide du capteur 7, dans le pain de sculpture 6, des contraintes de cisaillement longitudinales $\sigma_x$, des contraintes de cisaillement transversales $\sigma_y$ et des contraintes de pression $\sigma_z$. Toutes ces mesures sont effectuées pour un capteur 7, sensiblement au centre d'un pain de sculpture ou d'une zone de mesures. Ces mesures correspondent à des contraintes locales, à l'endroit du pain.

Les sommes respectives de toutes ces contraintes locales pour l'ensemble des pains au contact de la chaussée le long de l'aire de contact et pour chacun des axes respectifs X, Y et Z, représentent respectivement les forces et/ou contraintes globales longitudinales, transversales et normales appliquées au centre de la bande de roulement du pneumatique.

La présente description n'a pas pour objet de décrire les moyens et la méthode de mesure d'un capteur 7 que l'on peut trouver notamment dans le document EP 1 275 949 A1. Les capteurs utilisés fonctionnent selon différentes technologies, il peut s'agir de jauges piézo-électriques ou piezo-résistives ou de condensateurs. On peut ainsi, par exemple, associer un capteur à effet Hall avec son élément magnétique l'ensemble étant noyé dans la gomme du pneumatique. On pourra pour plus de précision concernant les technologies employées pour ces capteurs également se reporter à la lecture du document US-B-6 666 079 qui donne une description concernant différents capteurs de contrainte utilisés dans la bande de roulement d'un pneumatique.

Grâce à la connaissance de ces contraintes locales, on en déduit l'adhérence locale $\mu_{local}$. Elle se calcule de façon plus ou moins simplifiée selon le type et le nombre de contraintes détectées et mesurées.

Ainsi l'adhérence locale du pneumatique selon l'axe X est telle que : $\mu_{local\,x} = \sqrt{\dfrac{\sigma_x^{\,2}}{\sigma_z^{\,2}}}$ ; l'adhérence locale

selon l'axe $\mu_{local\,y} = \sqrt{\dfrac{\sigma_y^{\,2}}{\sigma_z^{\,2}}}$ et, de façon plus complète, selon les deux axes X et Y : $\mu_{local} = \sqrt{\dfrac{\sigma_x^{\,2} + \sigma_y^{\,2}}{\sigma_z^{\,2}}}$ .

La contrainte normale $\sigma_z$, dite de pression, s'établit de façon significative approximativement dès l'entrée d'un élément 6 équipé de son capteur 7 dans l'aire de contact avec le sol et ce jusqu'à sa sortie de l'aire de contact. Cette contrainte normale est sensiblement constante durant toute la traversée d'un élément 6 dans l'aire de contact car elle correspond très sensiblement à la caractéristique de pression de contact du pneumatique sur la route.

Ainsi, de façon simplifiée, on peut également acquérir une mesure du $\mu_{local}$ selon l'axe X comme étant égal à la simple valeur absolue de $\sigma_x$ ($\mu_{localx} = |\sigma_x|$) et de la même façon, un $\mu_{local}$ selon l'axe Y égal à la valeur absolue de

$\sigma_y$ ($\mu_{localy} = |\sigma_y|$) et plus généralement $\mu_{local} = \sqrt{\sigma_x^{\,2} + \sigma_y^{\,2}}$ .

Selon les contraintes locales détectées par le capteur 7, on mesure des contraintes longitudinales qui correspondent à des forces permettant de transmettre la motricité du pneumatique c'est-à-dire le freinage et l'accélération, et selon l'axe transversal y, des forces permettant de guider le véhicule et impliquant une dérive du pneumatique.

Dans toute la description, il faut comprendre « contrainte » dans un sens large qui correspond à des mesures effectives de contraintes, ou d'efforts, ou de déplacements ou de déformations. Les efforts et les déformations sont liés par des relations bien connues de l'homme du métier.

Dans le même esprit, on désigne indifféremment par adhérence locale $\mu_{local}$, le $\mu_{local}$ établi selon l'une ou l'autre des relations décrites précédemment.

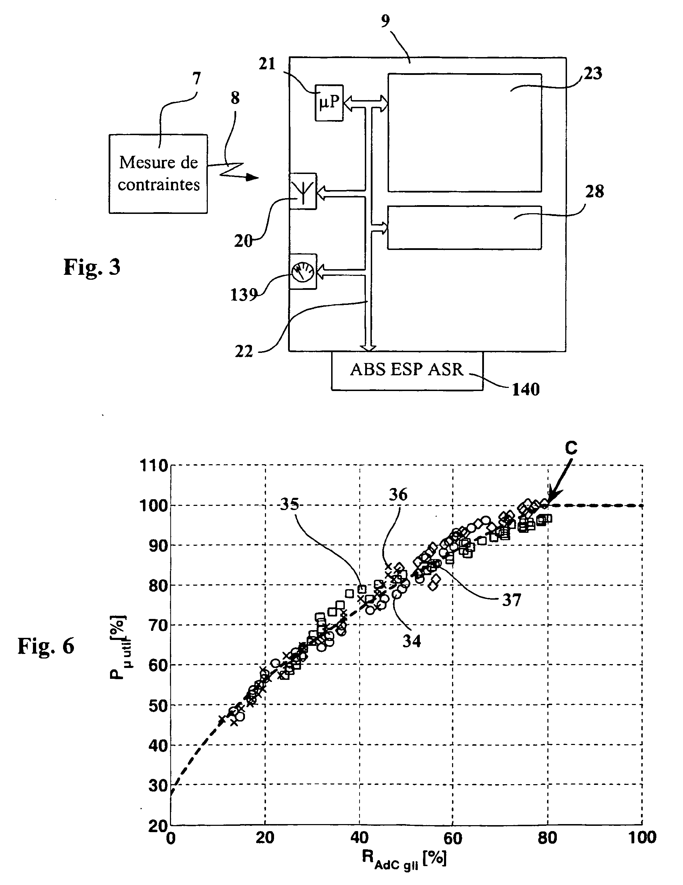

La figure 3 illustre le dispositif de mesure de l'invention comportant les capteurs 7 de mesure de contraintes ainsi que des moyens 8 de transmission du signal produit par ces capteurs 7 à une unité de traitement 9 de signaux. Le module de traitement 9 est, de préférence, placé dans le véhicule. On peut, dans une variante, placer ce module 9 dans le pneumatique lui-même. Selon cette variante, d'autres moyens de transmission sont nécessaires pour transmettre le signal traité aux organes ou au conducteur du véhicule.

L'homme de métier connaît par ailleurs les différentes formes possibles de moyens de transmission pour transmettre un signal entre un pneumatique et le véhicule. On peut, à cet effet, se reporter au document EP-A-1 350 640 qui illustre notamment un moyen dans lequel une antenne est implantée dans le pneumatique. Cette antenne est positionnée à l'intérieur même de la bande de roulement 2 et est reliée par un câble au capteur 7.

Il peut s'agir d'une antenne de champ électrique de type quart d'onde, ou encore de type modulation de fréquence ou d'amplitude de signal de puissance. Il est utile de préciser ici, qu'une antenne primaire fixée sur le véhicule en regard d'une antenne secondaire placée dans le pneumatique permet également, par effet d'inductance, une transmission de puissance de l'antenne primaire reliée par exemple à la batterie du véhicule à l'antenne secondaire de façon à fournir en énergie le capteur 7 de mesure. Une micro batterie insérée avec le capteur 7 dans un insert pré moulé de la bande de roulement 2 peut aussi assurer cette fonction.

Sur la figure 3, le signal correspondant aux mesures de contrainte est transmis, par les moyens 8, à l'unité de traitement 9, après réception par une antenne 20.

Par ailleurs, le fonctionnement du capteur 7 est de préférence piloté par un circuit électronique de mesure de type CIAS (circuit électronique intégré à une application spécifique) réalisant un codage de la mesure, le tout avant la transmission des mesures constituant le signal à analyser. L'antenne 20 est reliée à un micro processeur 21 de l'unité de traitement 9 via un bus 22 de jonction interne de données, d'adresses et de commandes.

L'unité de traitement 9, relié au bus 22, comporte une mémoire programme 23. Le programme mémorisé dans cette mémoire programme 23 permet, selon différentes sections de programmes, de traiter le signal extrait jusqu'au calcul du potentiel d'adhérence globale disponible $P_{\mu\,dispo}$. Elle comporte aussi une mémoire de données 28 destinée à recevoir et conserver en mémoire les données spécifiques du pneumatique du dispositif.

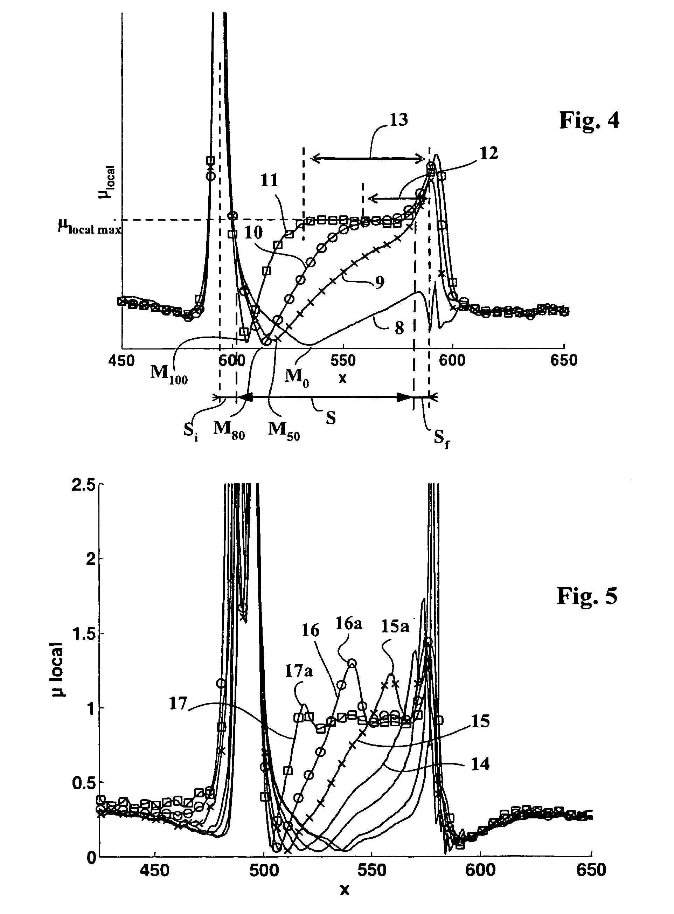

Ainsi sur la figure 4 est présentée en ordonnée l'adhérence locale $\mu_{local}$ d'un pain de sculpture déterminée selon des contraintes à la fois transversales et longitudinales. Le $\mu_{local}$ est une grandeur adimensionnelle et s'exprime donc sous la forme d'un simple coefficient ; de plus sur la figure 4, il n'est pas explicitement donné car seule son évolution nous intéresse. En abscisse, la courbe est étudiée selon le nombre de mesures prises durant un tour de pneumatique : en l'occurrence, dans ce cas, 1024 mesures sont prises le long du déploiement linéaire d'une circonférence totale correspondant à un tour de pneumatique. Pour autant, les mesures significatives des capteurs sont détectées entre un indice de mesure de 480 jusqu'à un indice de mesure d'environ 600. On peut résumer ainsi qu'environ une centaine de capteurs sur les 1024 déployés linéairement le long d'une circonférence subissent des contraintes significatives à un instant donné.

Cette courbe est également obtenue en employant un même et unique capteur subissant des contraintes significatives prises selon une fréquence déterminée, à intervalles de temps réguliers. Ainsi, en connaissant la vitesse du véhicule lors de ces mesures, on en déduit de la même façon l'évolution de $\mu_{local}$ le long de la longueur de l'aire de contact déployée.

Les mesures expérimentales sont réalisées sur un pneu Michelin 195 65 R15 XH1 Energy selon une charge de 400 déca-Newton et selon une pression de gonflage de 2 bars. Les 4 courbes 8, 9, 10 et 11 obtenues respectivement en trait plein, avec des croix, avec des ronds et avec des carrés, sont prises pour des couples freineurs respectifs nuls, de 50 daN.m (décaNewton mètre), de 80 daN.m, et enfin de 100 daN.m.

La courbe 8, sans couple freineur, correspond à un roulage libre pour lequel un signal est bien détecté entre le point de mesure 500 et le point de mesure 590 environ. La forme du signal obtenu avant ce point de mesure n°500 n'est pas significative, car elle correspond au moment où le capteur entre dans l'aire de contact, et où le dénominateur correspondant à la contrainte normale selon l'axe Z est nul ou quasiment nul. De la même façon, les signaux ou les mesures de signaux erratiques obtenus après le point de mesure n°590 correspondent à la sortie du capteur de l'aire de contact, ce jusqu'à environ la mesure 600 après laquelle, le signal ne correspond à aucune contrainte significative. Entre les deux points de mesures 590 et 600 environ, le signal obtenu est pollué par différents phénomènes physiques, notamment le passage, à nouveau, par une contrainte normale nulle et par un phénomène de détente élastique des pains retenus contre la chaussée. Ainsi, l'aire de contact représentative correspondant à des mesures de contraintes significatives sera comprise entre environ la mesure 500 et la mesure 590, soit un signal significatif amputé à chaque extrémité de deux parties respectivement en début ($S_i$) et en fin de signal ($S_f$) représentant 5 à 10 % du signal total. On peut donc considérer globalement que l'aire de contact est échantillonnée pour un nombre d'environ 70 à 75 points de mesure. C'est précisément ce signal restant représenté par une portion (S), comprise entre les parties (Si) et ($S_f$) qui est analysé.

Une première partie de la courbe 8 est située avant le point $M_0$ correspondant à l'indice de mesure 535. Dans cette partie, un pain situé dans l'aire de contact est tiré vers l'avant, le pneumatique, bien qu'en roulage libre sollicite localement au sol une adhérence non nulle, le point de passage du capteur aux environs de l'aplomb du moyeu du pneumatique se trouve au point $M_0$ où l'adhérence sollicitée est quasiment nulle, puis la seconde partie située entre le point de mesure 535 et le point de mesure 590 correspond à une partie où le pneumatique génère localement, à chaque point de mesure, une contrainte négative correspondant à un élément tiré vers l'arrière, à l'opposé du sens de roulage du pneu. Le point $M_0$ ne se situe pour autant pas au centre de l'aire de contact telle que déterminée, mais légèrement en amont du centre, cela s'explique, selon l'endroit de mesure, par des répartitions d'efforts différentes dans la largeur de l'aire de contact.

Sur la courbe 9, lorsqu'un couple freineur de 50 daN.m est appliqué, le signal obtenu comporte une première partie située avant le point $M_{50}$, point où l'adhérence locale utilisée est la plus faible et où le pain / capteur n'est quasiment pas déformé en cisaillement, sensiblement identique à la première partie de la courbe 8. En revanche, cette première partie comporte une pente descendante plus accentuée. Le pneumatique conserve une motricité positive à l'avant de l'aire de contact mais elle est plus réduite et tirée vers l'avant. Cette contrainte dans le sens de l'axe de roulement du pneumatique est moindre du fait du ralentissement provoqué par l'action du couple freineur. Le passage du capteur au point de plus faible cisaillement du pain intervient plus tôt et se situe aux alentours de l'indice de mesure 525.

La seconde partie de la courbe 9 indique également une valeur absolue des contraintes négatives opposées au sens de roulement tirant le pain de sculpture local vers l'arrière, à l'opposé du sens de roulage, de façon plus intense que pour le roulage libre. La seconde partie située après le point $M_{50}$ possède une pente bien plus importante mais croissant régulièrement jusqu'à la sortie du capteur de l'aire de contact. Cette seconde partie correspond à un cisaillement freineur local du pain dans l'aire de contact, ce cisaillement local s'effectuant sous la forme d'une déformation progressive du pain qui transmet alors le couple de freinage au pneu au contact de la chaussée. La pente de cette seconde partie de la courbe 9 indique que cela s'effectue de façon régulière et progressive jusqu'à la sortie du capteur de l'aire de contact : aucun phénomène de saturation ou de glissement n'est détecté.

Le phénomène de freinage, au-delà d'une certaine intensité, peut comporter un glissement, léger, au moins local, du pneumatique par rapport à la chaussée. Ce glissement local de freinage augmente alors avec l'effort de freinage, jusqu'au décrochement. Le décrochement se produit lorsque, au moins localement, le pneumatique ou un ou plusieurs de ses pains glisse sans plus générer d'effort supplémentaire. La saturation correspond à cet effort local limite de freinage.

En ce qui concerne les courbes 10 et 11 correspondant respectivement aux couples freineurs de 80 et 100 daN.m, leur première partie se décale selon la tendance décrite précédemment, avec des points $M_{80}$ et $M_{100}$ placés de plus en plus tôt le long de l'aire de contact. Leurs secondes parties, situées après les points $M_{80}$ et $M_{100}$, possèdent des pentes positives de plus en plus importantes. Mais on constate, dès la courbe 10 à l'indice de mesure 560 environ, une stagnation de la valeur de l'adhérence $\mu_{local}$ pour les mesures prises le long de l'aire de contact.

A partir de cet indice de mesure jusqu'à la sortie du pain de mesure de l'aire de contact cette mesure est quasi-constante voire constante : la courbe présente un plateau car la déformation du pain est maximale et ne peut plus épouser l'évolution que lui impose l'augmentation du couple freineur. Cette partie constante 12 pour laquelle l'adhérence locale stagne indique alors un glissement local du pain.

Il en va de même pour la partie 13, à partir de l'indice de mesure d'environ 530 pour la courbe 11, jusqu'à également la sortie du pain de l'aire de contact. Cette partie 13 correspond également à un glissement local du pain.

Ainsi pour ces deux parties respectivement 12 et 13 des courbes 10 et 11, dès l'apparition du début de ces plateaux et de la stagnation de l'adhérence locale, le pain ne peut plus absorber, par sa simple rigidité, le phénomène de décélération du couple freineur. De façon simplifiée, le pain n'est plus au contact de la chaussée seulement en se déformant mais, du fait d'une déformation maximum, glisse en plus le long de cette zone de contact.

Pour les mesures expérimentales effectuées et selon les paramètres tels que décrits précédemment, cette contrainte de déformation reste maximale et pour autant quasi constante durant toute la durée du glissement local. Mais on peut comprendre que selon le revêtement de la chaussée, selon ses aspérités notamment, durant ce glissement, le pain subisse des oscillations dues à ce que lors d'un glissement local le pain se détende brusquement libéré, par exemple, par un relief particulier de la chaussée et subisse donc une contrainte négative inférieure à celle présente au début du glissement. Puis à la reprise de contact, le pain subit à nouveau une contrainte plus forte, le tout se traduisant ainsi par des oscillations de la valeur du $\mu_{local}$ saturé.

La détection d'un plateau sur une courbe d'un signal est connue pour l'homme de l'art à partir notamment de la comparaison de deux mesures successives mais ne constitue pas le seul moyen de détecter le début de glissement local d'un pain dans l'aire de contact.

L'invention distingue d'autres critères permettant de détecter, de façon fiable, un point de début de glissement local. Il s'agit ainsi de détecter une partie de la courbe pour laquelle l'évolution de l'adhérence locale est relativement faible.

On peut en effet considérer qu'avant le glissement local le pain de sculpture s'approche du maximum de la déformation qui lui est permise en fonction de la contrainte appliquée. En conséquence, à l'approche de ce point, la courbe de l'adhérence locale évolue très faiblement. Cela se mesure alors concrètement par la détection pour plusieurs points de mesure consécutifs d'une très faible variation des valeurs de cette même courbe. On calcule alors la dérivée première selon la variable x correspondante aux relevés de mesures le long de l'aire de contact $(\dfrac{d\mu_{local}}{dx})$. Il suffit alors que ce calcul aboutisse à une valeur inférieure à une constante $S1$ $(\dfrac{d\mu_{local}}{dx} \prec S1)$ et ce, pour un nombre de points consécutifs pour que le glissement local soit détecté. Ce nombre de points correspond sensiblement à un nombre équivalent à 10 % du nombre de points de mesure sur une aire de contact : dans l'exemple donné, sur 75 points de mesure extraits du signal dans l'aire de contact, on calcule cette dérivée première pour 7 points de mesures consécutifs. La constante S 1 correspond à une constante dépendante à la fois non seulement du pneumatique mais aussi du pain de mesure étudié selon qu'il se situe, par exemple, sur la bande de roulement centrale ou sur l'épaule du pneumatique.

A titre indicatif, dans l'exemple donné de la figure 4, cela représente un coefficient de 0,02, soit une amplitude de variation du $\mu_{local}$ de 0,14 sur un nombre de 7 points d'échantillonnage ou 7 points de mesure. Selon ce critère, en se reportant à la courbe 9 de la figure 4, aucune phase de glissement ne serait donc ainsi détectée car l'évolution de l'adhérence locale se fait selon une différence supérieure à celle donnée précédemment. En revanche, pour les courbes notamment 10 et 11, les plateaux respectivement 12 et 13 peuvent être détectés grâce à ce premier critère dès les indices de mesure respectivement 560 et 530 environ, grâce à l'évolution de l'adhérence locale extrêmement faible marquant le début du glissement local du pain.

Un second critère peut également être mis en place pour la détection du glissement local, consistant non plus à déterminer une faible évolution des valeurs d'adhérence locale sur un nombre de points de mesure donnés, mais à déterminer une variation brutale de la pente d'évolution de cette adhérence.

On se situe alors dans une partie de la courbe qui se trouve entre la partie où le $\mu_{local}$ évolue selon une pente supérieure à la constante S1 précédemment donnée et la partie de la courbe où l'évolution se fait de façon très peu sensible principalement le plateau. A la jonction de ces deux parties, la pente évolue de façon relativement brutale. Il est intéressant, dès lors de détecter cette partie de la courbe précédant le début d'une pente faible, voire d'un plateau, et par conséquent d'un début de glissement local.

La valeur absolue de la dérivée seconde par rapport à la variable x correspondante aux relevés de mesures le long de l'aire de contact permet de calculer une valeur qui, si elle est supérieure à une constante

$S2$ $(\dfrac{d^2 \mu_{local}}{dx^2} \succ S2)$, permet de conclure à la détermination d'un point de début de glissement local. La constante S2 dépend également du pneu, du pain sur lequel s'effectuent les mesures, mais aussi du type de capteur qui prend la mesure. Pour les mesures expérimentales effectuées, ce paramètre S2 est de l'ordre de 0,007.

Sur la figure 5, on retrouve des courbes sensiblement similaires à celles de la figure 4, ce pour un sol légèrement différent et pour des courbes respectivement 14, 15, 16 et 17 subissant des couples freineurs respectivement de 50, 75, 100 et 115 daN.m.

Sur les courbes 15, 16 et 17 on distingue l'apparition d'un plateau de plus en plus grand. On observe également une variation brutale de la pente au passage d'un pic précédant ce plateau. Ainsi les deux premiers critères de détection d'un point de début de glissement local sont vérifiés.

On constate expérimentalement qu'en amont du plateau lui même se distingue le passage de l'adhérence locale par un maximum sous la forme d'un pic, notamment aux points 15a, 16a et 17a. Au sommet de ces pics, avant le plateau correspondant au glissement local, se trouve le maximum de la valeur du $\mu_{local}$ qui correspond au début de glissement du pain de sculpture. Pour autant, ce maximum $\mu_{localmax}$ n'existe pas systématiquement avant le glissement local du pain, comme par exemple pour les courbes 10 et 11 où un glissement local existe et est détecté mais où aucun maximum $\mu_{localmax}$ n'est visible. Ce maximum local, facilement détectable et identifiable par l'homme de l'art, peut alors être utilisé comme critère supplémentaire mais non déterminant et employé en complément d'un des deux ou des deux critères précédemment décrits dans le but d'améliorer la robustesse de la détection.

Les courbes de signal étudiées selon les critères précédemment décrits pourront au préalable subir un programme de lissage polynomial, connu de l'homme de l'art afin de gommer les éventuelles oscillations parasites dues aux vibrations ou aux interférences mécaniques de contact du pneumatique au sol. Il est constaté expérimentalement à partir de ces mesures, qu'à partir du moment où un glissement local est observé pour un pain 6 dans une aire de contact, ce glissement s'effectue jusqu'à la sortie de ce même pain de l'aire de contact.

La figure 6 représente un ensemble de courbes obtenues expérimentalement et permettant de relier une grandeur locale, le pourcentage de l'aire de contact glissante $(R_{adc\ gli})$, d'une part et une grandeur globale, le potentiel d'adhérence utilisé $P_{\mu\ util}$. Le pourcentage de l'aire de contact glissante est déterminé à partir des mesures d'efforts réalisées au moyen du ou des capteurs 7 du dispositif 3, et le potentiel d'adhérence utilisé est déterminé à partir de mesures d'efforts au centre roue. Ces courbes sont obtenues pour des conditions expérimentales variées.

Le potentiel d'adhérence utilisé $P_{\mu\ util}$ est calculé comme étant le rapport entre l'adhérence $\mu$ au moment de la mesure sur l'adhérence maximale $\mu_{max}$ connue et faisant l'objet d'une première mesure expérimentale. Le type d'adhérence $\mu$ mesuré expérimentalement et utilisé dans le calcul est ainsi celui défini plus haut dans sa forme globale ; $P_{\mu\ util}$ représente bien une grandeur globale du pneumatique.

Le traitement des données locales fournies par le ou les capteurs 7 est le suivant: on commence par déterminer la longueur d'aire de contact totale $L_{adc}$. Celle-ci correspond au déploiement linéaire du nombre de capteurs dans l'aire de contact ou, à la durée, pour un capteur, pendant laquelle un signal de contrainte selon l'axe normal Z est mesuré et est supérieur à un seuil correspondant à une contrainte significative.

On établit ensuite une courbe représentant l'évolution de l'adhérence locale $\mu_{local}$ en fonction de la position sur l'axe longitudinal X d'un élément ou pain 6 présent dans l'aire de contact, on identifie le point de début de glissement local du pain de mesure 6 avec le point de saturation de la courbe $\mu_{local}$ en fonction de X et on en déduit la longueur de glissement de l'élément 6 dans l'aire de contact : $L_{adc\ gli}$. Pratiquement, la détermination de cette grandeur $L_{adc\ gli}$ se réalise en mesurant la longueur d'un plateau de mesures constantes, non évolutives et successives de l'adhérence locale dans l'aire de contact.

Puis, à partir de ces deux grandeurs $L_{adc}$ et $L_{adc\ gli}$, on calcule un rapport $R_{adc\ gli}$ définissant la longueur de l'aire de contact glissante $L_{adc\ gli}$ sur la longueur de l'aire de contact totale $L_{adc}$. Ce rapport $R_{adc\ gli}$ indique le pourcentage d'aire de contact glissante et représente une grandeur locale.

Ainsi, les courbes 34, 35, 36 et 37 de la figure 6 représentent l'évolution du potentiel d'adhérence utilisé $P_{\mu\ util}$ en fonction du rapport $R_{adc\ gli}$ selon différentes conditions de roulement. Ce rapport dont les valeurs sont comprises entre 0 et 1 est alors exprimé sous la forme d'un pourcentage entre 0% et 100%.

Selon l'invention, on a constaté sur les courbes obtenues, une corrélation étroite entre la grandeur globale $P_{\mu\ util}$ et le rapport $R_{adc\ gli}$. Les courbes 34, 35, 36 et 37 représentées respectivement par des cercles, des carrés, des croix et des losanges correspondent respectivement à un freinage sur un sol sec, un freinage sur un sol humide, à une dérive sur un sol sec et à une dérive sur un sol humide.

Selon ces courbes, on constate qu'il faut atteindre un potentiel d'adhérence utilisé $P_{\mu\,util}$ situé entre au minimum 30% et, au maximum, aux environs de 45% avant de constater l'apparition d'une aire de contact glissante. Cette apparition n'est sensible que lorsque le rapport $R_{adc\,gli}$ est de 10% c'est-à-dire que 10% de l'aire de contact glissante arrive.

Ainsi, avant le moindre effet de glissement local, 30% à 45% de l'adhérence disponible du pneumatique est exploitée. Ce résultat est dû à la déformation de chaque élément accompagnant un freinage.

Lorsque le potentiel d'adhérence utilisé $P_{\mu\,util}$ est maximum, l'adhérence utilisée correspond à l'adhérence maximale et l'on se trouve à un point C avec, en abscisse, 80% de pourcentage d'aire de contact glissante. En pratique, au-delà de ce point, le décrochage se produit très vite, l'adhérence du pneumatique diminue et risque de provoquer un patinage ou un blocage des roues selon qu'il s'agisse d'une accélération ou d'un freinage. Plus généralement, au-delà de ce point la perte d'adhérence peut engendrer une perte de contrôle du véhicule.

En pratique, les dispositifs d'assistance sont prévus pour intervenir selon un rapport de différence de vitesse entre le véhicule et une roue de l'ordre de 10% correspondant à un pneumatique standard. Or selon le type de pneumatique monté sur le véhicule, cette intervention peut correspondre à un moment où l'on exploite 75% comme 50% du potentiel d'adhérence disponible : le pneumatique n'est pas alors toujours utilisé au maximum ou proche du maximum de ses performances.

Selon l'invention, la relation établie entre $P_{\mu\,util}$ et $R_{adc\,gli}$ permet, à partir d'une valeur $R_{adc\,gli}$ mesurée sur le pneumatique, de déduire la valeur de la marge d'adhérence utilisée ou la valeur complémentaire sur un pourcentage de 100% : la marge d'adhérence disponible. De plus, l'information ainsi recueillie l'est, en pratique, directement à partir d'une grandeur physique du pneumatique au contact de la chaussée et ce en quelque millisecondes. Elle ne dépend pas d'une interprétation telle une différence de vitesse pour laquelle un dispositif de type ABS, ASR ou ESP travaille au dixième de seconde, après une régulation sur environ 10 tours de roue.

A partir des courbes expérimentales obtenues, on en déduit une relation empirique telle que :

$$P_{\mu\,util} = (R_{adc\,gli} + A)^B + C \ \text{ si } \ (R_{adc\,gli} + A)^B + C < 1 \ \text{ et}$$

$$P_{\mu\,util} = 1 \ \text{sinon,}$$

avec A, B et C des constantes dépendantes du type de pneumatique. Dans le cas des courbes de la figure 6 obtenues avec un pneumatique Michelin Energy 195/65R1XH1, ces constantes valent respectivement 0,0435, 0,522 et 0,0796. Ces constantes ne varient que très peu avec l'usure du pneumatique.

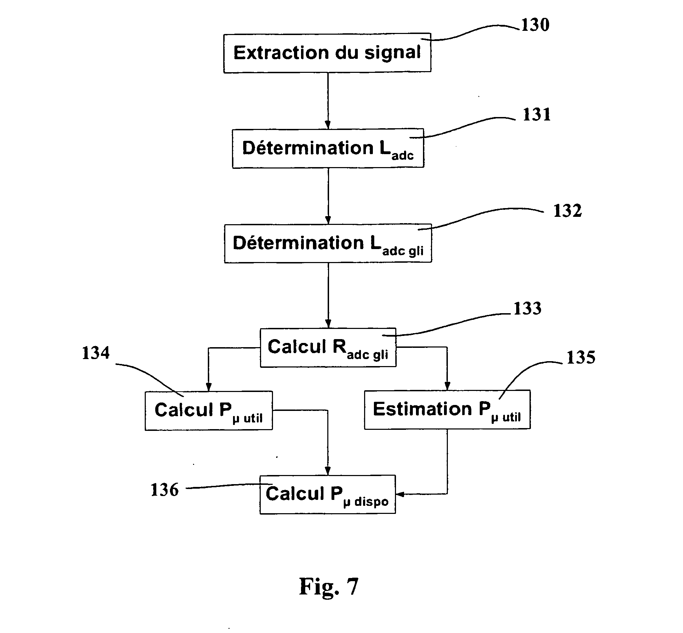

La figure 7 illustre schématiquement les étapes du procédé de traitement des données incorporé dans la mémoire programme 13 du dispositif selon l'invention.

La première étape de traitement 130 correspond à l'extraction des signaux des capteurs 7 dans l'aire de contact du pneumatique. Cette partie du signal reçu des capteurs 7 correspond à un signal de contrainte sensiblement non nul, par exemple typiquement supérieur à un seuil tel que décrit précédemment.

L'extraction du signal peut alors se faire selon deux critères.

Un premier critère consiste à compter le nombre de capteurs indiquant un signal de contrainte significatif supérieur à un seuil permettant de conclure à la présence de ces capteurs dans l'aire de contact sur le sol.

Un deuxième critère consiste à mesurer la durée pendant laquelle un capteur émet un signal significatif de mesure de contrainte, cette durée correspondant alors à son passage dans l'aire de contact.

A titre d'exemple, pour les contraintes longitudinales, on détermine tous les signaux correspondant à une mesure de contrainte dont la valeur absolue est supérieure à un millième de volt.

Grâce à l'un ou l'autre de ces deux critères, le nombre de capteurs déployés linéairement le long de la circonférence de la bande roulement étant connu, ainsi que la vitesse du pneumatique, on peut alors calculer à l'étape 131, respectivement pour le premier et le second critère, la longueur totale de l'aire de contact $L_{adc}$. Cette longueur peut se quantifier, par exemple, par un nombre de mesures.

De façon quasi-simultanée, à l'étape 132, on détermine en temps réel la longueur de l'aire de contact glissante en déterminant le point de début de glissement local, tel que décrit précédemment pour l'obtention des courbes de la figure 6. Cette détermination consiste, pour l'essentiel, à prendre en compte le point de début de glissement local et le point de sortie de l'aire de contact pour un même capteur. Entre ces deux points on obtient la longueur de l'aire de contact glissante $L_{adc\,gli}$. Un programme de calcul 133 détermine alors le rapport d'aire de contact glissant $R_{adc\,gli}$ en divisant la valeur obtenue à l'étape 132 par celle obtenue à l'étape 131.

Le dispositif de traitement 9 comporte également une mémoire de données 28. Cette mémoire de données 28 peut comporter des tables de corrélations de potentiels d'adhérence utilisée $P_{\mu\,util}$ en fonction de valeurs de rapports de l'aire de contact glissant $R_{adc\ gli}$ et ce, selon différentes conditions dynamiques de roulage. Ces tables sont acquises expérimentalement, type de pneumatique par type de pneumatique selon la méthode décrite ci-dessus. Par suite, à l'étape 134, on peut déterminer par interpolation la valeur de $P_{\mu\ util}$ en correspondance de la valeur de $R_{adc\ gli}$.

Plus simplement, la mémoire de données 28 peut ne comporter que les constantes A, B et C du pneumatique telles que déterminées au préalable à partir des résultats exposés précédemment (voir figure 6). Le calcul du potentiel d'adhérence utilisé $P_{\mu\ util}$ est alors très aisément réalisé à l'étape 135 à partir des valeurs du rapport $R_{adc\ gli}$.

Les A, B et C dépendantes du pneumatique étudié peuvent être sélectionnées lors de la monte d'un type de pneumatique sur le véhicule via le bus 22. $P_{\mu\ dispo}$ ou $P_{\mu\ util}$ peuvent être utilisés indifféremment.

Une fois la marge d'adhérence disponible $P_{\mu\ dispo}$ calculée, un affichage peut être assuré, via le bus de liaison 22, sur un afficheur 139 placé à l'intérieur même du véhicule. L'afficheur 139 se présente sous la forme, par exemple, d'un cadran affichant une donnée rapidement et facilement interprétable. Il s'agit principalement pour le conducteur de prendre en compte l'information afin de réguler en conséquence sa vitesse et en adaptant son type de conduite. La communication de $P_{\mu\ dispo}$ peut également être transmise, en plus ou seulement, aux différents dispositifs 140 de sécurité active tels les dispositifs d'anti-blocage de roues (ABS) de correction de trajectoire (ESP) ou d'anti-patinage (ASR).

Ces dispositifs 140 prennent en compte, selon les différentes vitesses, le comportement du pneumatique sur la chaussée. Il est donc intéressant pour ces derniers d'intégrer un critère physique tenant compte de la marge d'adhérence disponible $P_{\mu\ dispo}$. Ils disposent alors d'une donnée réelle et d'une estimation directe de $P_{\mu\ dispo}$ pour une intervention mieux calibrée et située au plus proche du maximum d'adhérence disponible du pneu.

L'invention n'est pas limitée aux exemples décrits et représentés et diverses modifications peuvent y être apportées sans sortir de son cadre défini par les revendications annexées.

## Revendications

**1.** Procédé d'estimation de la marge d'adhérence disponible d'un pneumatique d'un véhicule en roulage sur un sol, **caractérisé en ce qu'**il comporte les étapes suivantes :

- estimer une grandeur $R_{adc\ gli}$, rapport entre l'aire de contact en glissement et l'aire de contact totale du pneumatique sur le sol ;
- déterminer, dans une unité de traitement, à partir de ledit rapport et de données préétablies liées au type de pneumatique, le potentiel d'adhérence utilisé $P_{\mu\ util}$ et/ou la marge d'adhérence disponible du pneumatique $P_{\mu\ dispo}$, avec $P_{\mu\ dispo} = 1 - P_{\mu\ util}$ ; et
- enregistrer dans une mémoire le potentiel d'adhérence utilisé et/ou la marge d'adhérence disponible du pneumatique.

**2.** Procédé selon la revendication 1, dans lequel les données préétablies sont un abaque expérimental représentant l'évolution du potentiel d'adhérence utilisé $P_{\mu\ util}$ en fonction de valeurs du rapport $R_{adc\ gli}$ mesurées pour différentes conditions de roulage déterminées.

**3.** Procédé selon la revendication 1, dans lequel les données préétablies sont des coefficients A, B et C d'une formule analytique F telle que :

$$P_{\mu\ util} = (R_{adc\ gli} + A)^B + C \text{ si } (R_{adc\ gli} + A)^B + C < 1 \text{ et}$$

$$P_{\mu\ util} = 1 \text{ sinon,}$$

avec A, B et C des constantes dépendantes du type de pneumatique.

**4.** Procédé selon l'une des revendications 1 à 3, dans lequel la grandeur $R_{adc\ gli}$ est estimée à partir de la mesure du différentiel de vitesse entre la roue et le sol et à partir d'un modèle de fonctionnement du pneumatique reliant ce différentiel de vitesse à la grandeur $R_{adc\ gli}$.

**5.** Procédé selon l'une des revendications 1 à 3, dans lequel, un pain de sculpture de la bande de roulement du pneumatique étant équipé d'un ou plusieurs capteurs (7) permettant chacun de mesurer une grandeur caractéristique des sollicitations que subit localement le pain de sculpture lorsque le pneumatique roule sur le sol, on estime la grandeur $R_{adc\ gli}$ par les étapes suivantes :

- mesurer ladite grandeur caractéristique lorsque le pneumatique roule sur le sol ;
- produire un signal correspondant aux mesures réalisées ;
- extraire de ce signal une portion (S) relative au passage du ou des capteurs (7) dans l'aire de contact du pneumatique sur le sol et déterminer la longueur totale de l'aire de contact $L_{adc}$ ;
- déterminer, à partir de la portion extraite du signal une information caractérisant un début d'un glissement local du pain de sculpture (6) ;
- déterminer une longueur de glissement local du pain de sculpture de la bande de roulement $L_{adc\ gli}$ ; et
- calculer un rapport $R_{adc\ gli}$ tel que $R_{adc\ gli} = L_{adc\ gli} / L_{adc}$.

6. Procédé selon la revendication 5, dans lequel la grandeur caractéristique mesurée, située dans le plan du sol, est une contrainte longitudinale $\sigma_x$ selon la direction de roulement du pneumatique et/ou transversale $\sigma_y$ à la direction de roulement du pneumatique représentant l'adhérence locale $\mu_{local}$ ou $\mu_{localx}$ ou $\mu_{localy}$ du pain de sculpture (6) de la bande de roulement.

7. Procédé selon l'une des revendications 5 et 6, dans lequel la grandeur caractéristique mesurée est un rapport de contraintes représentant l'adhérence locale $\mu_{local}$ ou $\mu_{localx}$ ou $\mu_{localy}$ du pain de sculpture de la bande de roulement et correspond au rapport d'une mesure de contrainte longitudinale $\sigma_x$ et/ou transversale $\sigma_y$ à la direction de roulement sur une contrainte $\sigma_z$, normale à l'axe X de la direction de roulement.

8. Procédé selon l'une des revendications 5 à 7, dans lequel la portion extraite (S) du signal représente des valeurs de contraintes, en ordonnée, fonction, en abscisse, de la durée de passage d'un même capteur dans l'aire de contact ou des valeurs de contraintes, en ordonnée, fonction, en abscisse, de la position longitudinale x selon l'axe longitudinal correspondant à la direction de roulement, de la localisation de plusieurs capteurs présents le long de l'aire de contact.

9. Procédé selon l'une des revendications 5 à 8, dans lequel la portion extraite (S) du signal est amputée d'une première partie ($S_i$) dès la détection de l'entrée du pain de sculpture dans l'aire de contact et est amputée d'une seconde partie ($S_f$) juste avant la détection de la sortie du pain de sculpture de l'aire de contact.

10. Procédé selon la revendication 9, dans lequel chacune des parties amputées correspond à environ 7,5% de la portion extraite (S) du signal.

11. Procédé selon l'une des revendication 5 à 10, dans lequel l'information de début de glissement local est déterminée par la détection d'une constance de la portion extraite (S) du signal c'est-à-dire, par exemple, un plateau sensiblement horizontal sur une courbe représentant la portion extraite (S) du signal.

12. Procédé selon l'une des revendication 5 à 11, dans lequel le point de début de glissement local est déterminé lorsque la dérivée première de l'adhérence locale $\mu_{local}$ par rapport à la variable x est inférieure à une valeur S1 ce, pour n points de mesures consécutifs relevés le long de l'aire de contact, avec :

- x, représentant une position longitudinale selon l'axe longitudinal correspondant à la direction de roulement du pneumatique du et/ou des pains de sculpture (6) ; et
- S1 et n, des constantes fonctions, à la fois, du pneumatique et du pain de mesure étudié.

13. Procédé selon l'une des revendications 5 à 12, dans lequel le point de début de glissement local est déterminé lorsque la valeur absolue de la dérivée seconde de l'adhérence locale $\mu_{local}$ par rapport à la variable x est supérieure à une valeur S2, avec

- x, représentant une position longitudinale selon l'axe longitudinal correspondant à la direction de roulement du pneumatique du et/ou des pains de sculpture (6) ;
- S2, une constante fonction, à la fois, du pneumatique et du pain de mesure (6) étudié et du capteur (7) employé.

14. Procédé selon l'une des revendications 12 et 13, dans lequel le point de début de glissement local est déterminé lorsque, en plus d'un premier critère de détermination de ce même point, l'adhérence locale $\mu_{local}$ passe par un maximum $\mu_{localmax}$.

15. Procédé selon l'une quelconque des revendications précédentes, dans lequel l'estimation de la marge d'adhérence disponible $P_{\mu\ dispo}$ est transmise aux différents dispositifs de sécurité active embarqués dans le véhicule.

**16.** Procédé selon l'une quelconque des revendications précédentes, dans lequel l'estimation de la marge d'adhérence disponible $P_{\mu\ dispo}$ est transmise au conducteur du véhicule.

**17.** Dispositif d'estimation de la marge d'adhérence disponible d'un pneumatique (1) d'un véhicule évoluant sur un sol, comportant :

- un pneumatique dont au moins un pain de sculpture ou une zone de mesure de la bande de roulement est équipé d'un ou plusieurs capteurs (5) permettant, chacun, de mesurer les contraintes subies localement par le pain de sculpture ou la zone de mesure de la bande de roulement du pneumatique en roulage sur le sol,
- des moyens de transmission d'un signal correspondant aux mesures de ces contraintes ;
- une unité de traitement de signaux capable d'extraire du signal transmis, une portion de signal correspondant au nombre ou à la durée de passage du ou des capteurs dans l'aire de contact du pneumatique en roulage sur le sol ;

**caractérisé en ce qu'**il comporte, dans l'unité de traitement, un programme pour, à partir du signal extrait, mettre en oeuvre le procédé selon l'une quelconque des revendications 5 à 16.

**Claims**

**1.** Method of estimating the available grip margin of a tyre of a vehicle rolling on a ground, **characterized in that** it comprises the following steps:

- estimating a quantity $R_{slip\ ca}$, i.e. the ratio of the slip contact area and the total contact area of the tyre on the ground;
- determining, in a signal processing unit, the grip potential used $P_{\mu,used}$ and/or the available grip margin of the tyre $P_{\mu,avail}$ from said quantity and pre-established data connected with the type of tyre, where $P_{\mu,avail} = 1 - P_{\mu,used}$; and
- recording in a memory the grip potential used and/or the available grip margin of the tyre.

**2.** Method according to Claim 1, in which the pre-established data is in the form of an experimental chart representing the change in grip potential used $P_{\mu,used}$ as a function of the measured values of the ratio $R_{slip\ ca}$ for various determined rolling conditions.

**3.** Method according to Claim 1, in which the pre-established data is in the form of coefficients A, B and C of an analytic formula F such that:

$$P_{\mu,used} = (R_{slip\ ca} + A)^B + C \text{ if } (R_{slip\ ca} + A)^B + C < 1 \text{ and}$$
$$P_{\mu,used} = 1 \text{ otherwise}$$

where A, B and C are constants dependent on the type of tyre.

**4.** Method according to one of Claims 1 to 3, in which the quantity $R_{slip\ ca}$ is estimated from the measurement of the speed differential between the wheel and the ground and from a model of the operation of the tyre that connects this speed differential to the quantity $R_{slip\ ca}$.

**5.** Method according to one of Claims 1 to 3, in which, when a tread pattern block of the tyre is equipped with one or more sensors (7), each for measuring a characteristic quantity of the stresses undergone locally by the tread pattern block when the tyre is rolling on the ground, the quantity $R_{slip\ ca}$ is estimated by the following steps:

- measuring said characteristic quantity when the tyre is rolling on the ground;
- generating a signal corresponding to the measurements made;
- extracting from this signal a portion (S) relating to the sensor or sensors (7) passing into the contact area of the tyre on the ground and determining the total length of the contact area $L_{ca}$;
- determining information characterizing the onset of local slip of the tread pattern block from the extracted portion of the signal;

- determining a local slip length $L_{slip\,ca}$ of the tread pattern block; and
- calculating a ratio $R_{slip\,ca}$ such that $R_{slip\,ca} = L_{slip\,ca}/L_{ca}$.

6. Method according to Claim 5, in which the measured characteristic quantity, in the plane of the ground, is a longitudinal stress $s_x$ along the rolling direction of the tyre and/or a transverse stress $s_y$ transverse to the direction of the rolling direction of the tyre, representing the local grip $\mu_{local}$ or $\mu_{local,x}$ or $\mu_{local,y}$ of the tread pattern block (6).

7. Method according to either of Claims 5 and 6, in which the measured characteristic quantity is a ratio of stresses representing the local grip $\mu_{local}$ or $\mu_{local,x}$ or $\mu_{local,y}$ of the tread pattern block and corresponds to the ratio of measurement of the longitudinal stress $s_x$ and/or the transverse stress $s_y$, with respect to the rolling direction, to a stress $s_z$ normal to the X-axis of the rolling direction.

8. Method according to one of Claims 5 to 7, in which the extracted portion (S) of the signal represents stress values, as ordinates, as a function, as abscissae, of the time during which a given sensor passes into the contact area or represents stress values, as ordinates, as a function, as abscissae, of the longitudinal position x, along the longitudinal axis corresponding to the rolling direction, of the location of several sensors present along the contact area.

9. Method according to one of Claims 5 to 8, in which a first part ($S_i$) of the extracted portion (S) of the signal is removed therefrom as soon as the entry of the tread pattern block enters the contact area and a second part ($S_f$) is removed therefrom just before the exit of the tread pattern block from the contact area is detected.

10. Method according to Claim 9, in which each of the removed parts corresponds to about 7.5% of the extracted portion (S) of the signal.

11. Method according to one of Claims 5 to 10, in which the local slip onset information is determined by detecting a constant level of the extracted portion (S) of the signal, i.e., for example, an approximately horizontal plateau on a curve representing the extracted portion (S) of the signal.

12. Method according to one of Claims 5 to 11, in which the local slip onset point is determined when the first derivative of the local grip $\mu_{local}$ with respect to the variable x is below a value S1 for n consecutive measurement points recorded along the contact area, where:

   - x represents a longitudinal position along the longitudinal axis, corresponding to the rolling direction of the tyre of the tread pattern block and/or blocks (6); and
   - S1 and n are constant functions both of the tyre and of the measurement block studied.

13. Method according to one of Claims 5 to 12, in which the local slip onset point is determined when the absolute value of the second derivative of the local grip $\mu_{local}$ with respect to the variable x is above a value S2, where:

   - x represents a longitudinal position along the longitudinal axis, corresponding to the rolling direction of the tyre of the tread pattern block and/or blocks (6); and
   - S2 is a constant function both of the tyre and of the measurement block (6) studied and of the sensor (7) employed.

14. Method according to either of Claims 12 and 13, in which the local slip onset point is determined when, in addition to a first criterion for determining this same point, the local grip $\mu_{local}$ passes through a maximum $\mu_{local,max}$.

15. Method according to any one of the preceding claims, in which the estimate of the available grip margin $P_{\mu,avail}$ is transmitted to the various active safety devices on board the vehicle.

16. Method according to any one of the preceding claims, in which the estimate of the available grip margin $P_{\mu,avail}$ is transmitted to the driver of the vehicle.

17. Device for estimating the available grip margin of a tyre (1) of a vehicle travelling over a ground, comprising:

   - a tyre, at least one tread pattern block of which or a measurement zone of the tread of which is equipped with one or more sensors (5), each for measuring the stresses undergone locally by the tread pattern block or the measurement zone of the tread of the tyre when rolling on the ground;

- means for transmitting a signal corresponding to the measurements of these stresses; and
- a signal processing unit capable of extracting, from the transmitted signal, a signal portion corresponding to the number or to the duration of passage of the sensor or sensors in the contact area of the tyre rolling on the ground;

**characterized in that** it includes, in the processing unit, a program for implementing, on the basis of the extracted signal, the method according to any one of Claims 5 to 16.

**Patentansprüche**

1. Verfahren zur Schätzung des verfügbaren Haftbereichs eines Luftreifens eines Fahrzeug beim Rollen auf einem Boden, **dadurch gekennzeichnet, dass** es die folgenden Schritte aufweist:

   - Schätzen einer Größe $R_{adc\,gli}$, Verhältnis zwischen der Gleitschlupf-Kontaktfläche und der Gesamtkontaktfläche des Luftreifens mit dem Boden;
   - Bestimmen, in einer Verarbeitungseinheit, ausgehend von dem Verhältnis und von vorher festgelegten Daten, die mit dem Luftreifentyp verbunden sind, des verwendeten Haftpotentials $P_{\mu\,util}$ und/oder des verfügbaren Haftbereichs des Luftreifens $P_{\mu,\,dispo}$, mit $P_{\mu,\,dispo} = 1 - P_{\mu,\,util}$; und
   - Eintragen des verwendeten Haftpotentials und/oder des verfügbaren Haftbereichs des Luftreifens in einen Speicher.

2. Verfahren nach Anspruch 1, bei dem die vorher festgelegten Daten ein experimentelles Nomogramm sind, das die Entwicklung des verwendeten Haftpotentials $P_{\mu\,util}$ in Abhängigkeit von Werten des Verhältnisses $R_{adc\,gli}$ darstellt, die für verschiedene bestimmte Fahrbedingungen gemessen werden.

3. Verfahren nach Anspruch 1, bei dem die vorher festgelegten Daten Koeffizienten A, B und C einer analytischen Formel F sind, derart, dass gilt:

$$P_{\mu\,util} = (R_{adc\,gli} + A)^B + C \text{ wenn } (R_{adc\,gli} + A)^B + C < 1$$
$$\text{und sonst } P_{\mu\,util} = 1,$$

mit A, B und C Konstanten, die vom Luftreifentyp abhängen.

4. Verfahren nach einem der Ansprüche 1 bis 3, bei dem die Größe $R_{adc\,gli}$ ausgehend von der Messung des Geschwindigkeitsdifferentials zwischen dem Rad und dem Boden und ausgehend von einem Betriebsmodell des Luftreifens geschätzt wird, das dieses Geschwindigkeitsdifferential mit der Größe $R_{adc\,gli}$ verbindet.

5. Verfahren nach einem der Ansprüche 1 bis 3, bei dem, wenn ein Profilblock des Laufstreifens des Luftreifens mit einem oder mehreren Sensoren (7) ausgestattet ist, die es je ermöglichen, eine Wirkungsgröße der beim Rollen des Luftreifens auf dem Boden vom Profilblock lokal erfahrenen Beanspruchungen zu messen, die Größe $R_{adc\,gli}$ durch die folgenden Schritte geschätzt wird:

   - Messen der Wirkungsgröße, wenn der Luftreifen auf dem Boden rollt;
   - Erzeugen eines den durchgeführten Messungen entsprechenden Signals;
   - Entnahme aus diesem Signal eines Anteils (S) bezüglich des Durchgangs des oder der Sensoren (7) durch die Kontaktfläche des Luftreifens auf dem Boden und Bestimmen der Gesamtlänge der Kontaktfläche $L_{adc}$;
   - Bestimmen, ausgehend vom entnommenen Anteil des Signals, einer Information, die einen Beginn eines lokalen Gleitschlupfs des Profilblocks (6) kennzeichnet;
   - Bestimmen einer lokalen Gleitschlupflänge des Profilblocks des Laufstreifens $L_{adc\,gli}$; und
   - Berechnen eines Verhältnisses $R_{adc\,gli}$ derart, dass gilt $R_{adc\,gli} = L_{adc\,gli}/L_{adc}$.

6. Verfahren nach Anspruch 5, bei dem die gemessene Wirkungsgröße, die sich in der Ebene des Bodens befindet, eine Längsbelastung $\sigma_x$ in Richtung des Rollens des Luftreifens und/oder Querbelastung $\sigma_y$ zur Rollrichtung des Luftreifens ist, die die lokale Haftung $\mu_{local}$ oder $\mu_{localx}$ oder $\mu_{localy}$ des Profilblocks (6) des Laufstreifens darstellt.

7. Verfahren nach einem der Ansprüche 5 und 6, bei dem die gemessene Wirkungsgröße ein Verhältnis von Belastungen ist, das die lokale Haftung $\mu_{local}$ oder $\mu_{localx}$ oder $\mu_{localy}$ des Profilblocks des Laufstreifens darstellt und dem Verhältnis einer Messung einer Belastung $\sigma_x$ in Längsrichtung und/oder quer $\sigma_y$ zur Rollrichtung zu einer Belastung $\sigma_z$ orthogonal zur Achse X der Rollrichtung entspricht.

8. Verfahren nach einem der Ansprüche 5 bis 7, bei dem der entnommene Anteil (S) des Signals Belastungswerte in der Ordinate, abhängig, in der Abszisse, von der Durchgangsdauer des gleichen Sensors durch die Kontaktfläche, oder Belastungswerte in der Ordinate, abhängig, in der Abszisse, von der Längsposition x gemäß der Längsachse, die der Rollrichtung entspricht, der Lokalisierung mehrerer Sensoren darstellt, die entlang der Kontaktfläche vorhanden sind.

9. Verfahren nach einem der Ansprüche 5 bis 8, bei dem der entnommene Anteil (S) des Signals bei der Erfassung des Eintritts des Profilblocks in die Kontaktfläche um einen ersten Teil (Si) gekürzt wird, und kurz vor der Erfassung des Austritts des Profilblocks aus der Kontaktfläche um einen zweiten Teil (Sf) gekürzt wird.

10. Verfahren nach Anspruch 9, bei dem jeder der gekürzten Teile etwa 7,5 % des entnommenen Anteils (S) des Signals entspricht.

11. Verfahren nach einem der Ansprüche 5 und 6, bei dem die Information über den Anfang eines lokalen Gleitschlupfs durch die Erfassung einer Konstanz des entnommenen Anteils (S) des Signals, d.h. zum Beispiel einer im Wesentlichen waagrechten Ebene in einer den entnommenen Anteil (S) des Signals darstellenden Kurve, bestimmt wird.

12. Verfahren nach einem der Ansprüche 5 bis 11, bei dem der Anfangspunkt lokalen Gleitschlupfs bestimmt wird, wenn die erste Ableitung der lokalen Haftung $\mu_{local}$ bezüglich der Variablen x geringer ist als ein Wert S1, dies für n aufeinanderfolgende Messpunkte, die entlang der Kontaktfläche abgelesen werden, mit:

    - x eine Längsposition entlang der Längsachse darstellend, die der Rollrichtung des Luftreifens und/oder der Profilblöcke (6) entspricht; und
    - S1 und n Konstanten, die sowohl vom Luftreifen als auch vom untersuchten Profilblock abhängen.

13. Verfahren nach einem der Ansprüche 5 bis 12, bei dem der Anfangspunkt lokalen Gleitschlupfs bestimmt wird, wenn der Absolutwert der zweiten Ableitung der lokalen Haftung $\mu_{local}$ bezüglich der Variablen x höher ist als ein Wert S2, mit

    - x eine Längsposition entlang der Längsachse darstellend, die der Rollrichtung des Luftreifens und/oder der Profilblöcke (6) entspricht;
    - S2 einer Konstanten, die sowohl vom Luftreifen als auch vom untersuchten Profilblock (6) und vom verwendeten Sensor (7) abhängt.

14. Verfahren nach einem der Ansprüche 12 und 13, bei dem der Anfangspunkt lokalen Gleitschlupfs bestimmt wird, wenn zusätzlich zu einem ersten Bestimmungskriterium dieses Punkts die lokale Haftung $\mu_{local}$ durch ein Maximum $\mu_{localmax}$ geht.

15. Verfahren nach einem der vorhergehenden Ansprüche, bei dem die Schätzung des verfügbaren Haftbereichs $P_{\mu\,dispo}$ an die verschiedenen aktiven Sicherheitsvorrichtungen an Bord des Fahrzeugs übertragen wird.

16. Verfahren nach einem der vorhergehenden Ansprüche, bei dem die Schätzung des verfügbaren Haftbereichs $P_{\mu\,dispo}$ an den Fahrer des Fahrzeugs übertragen wird.

17. Vorrichtung zur Schätzung des verfügbaren Haftbereichs eines Luftreifens (1) eines auf einem Boden fahrenden Fahrzeugs, die aufweist:

    - einen Luftreifen, von dem mindestens ein Profilblock oder eine Messzone des Laufstreifens mit einem oder mehreren Sensoren (5) ausgestattet ist, die es je ermöglichen, die lokal vom Profilblock oder von der Messzone des Laufstreifens des Luftreifens beim Rollen auf dem Boden erfahrenen Belastungen zu messen,
    - Einrichtungen zur Übertragung eines den Messungen dieser Belastungen entsprechenden Signals;

- eine Signalverarbeitungseinheit, die aus dem übertragenen Signal einen Signalanteil entnehmen kann, der der Anzahl oder der Durchgangsdauer des oder der Sensoren durch die Kontaktfläche des Luftreifens beim Rollen auf dem Boden entspricht;

**dadurch gekennzeichnet, dass** sie in der Verarbeitungseinheit ein Programm aufweist, um ausgehend vom entnommenen Signal das Verfahren nach einem der Ansprüche 5 bis 16 durchzuführen.

**Fig. 1**

**Fig. 2**

Fig. 3

Fig. 6

Fig. 4

Fig. 5

**Extraction du signal** ⟶ 130

↓

**Détermination L$_{adc}$** ⟶ 131

↓

**Détermination L$_{adc\ gli}$** ⟶ 132

↓

**Calcul R$_{adc\ gli}$** ⟶ 133

134 ⟶ **Calcul P$_{\mu\ util}$**    **Estimation P$_{\mu\ util}$** ⟶ 135

136 ⟶ **Calcul P$_{\mu\ dispo}$**

**Fig. 7**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03066399 A
- EP 1275949 A1
- US 6666079 B
- EP 1350640 A